# EUROPEAN PATENT SPECIFICATION

(11) **EP 0 243 034 B1**
(45) Date of publication and mention of the grant of the patent: **28.07.1993**
(21) Application number: 87303030.8
(22) Date of filing: 08.04.1987
(51) Int. Cl.: H01L 23/52, H01L 27/02

(54) **Programmable bonding pad**
Programmierbarer Kontaktfleck
Plage de contact programmable

(30) Priority: 17.04.1986 US 853303
(43) Date of publication of application: 28.10.1987
(73) Proprietor: Exar Corporation, Sunnyvale California 94088 (US)
(72) Inventor: Giannella, Giovanni Piccolo, Sunnyvale California 94087 (US)
(74) Representative: Quest, Barry

(56) References cited:
- EP-A- 0 008 946
- DE-A- 3 431 632
- US-A- 3 573 488
- US-A- 4 295 149
- PATENT ABSTRACTS OF JAPAN, vol. 10, no. 113 (E-399)[2170], 26th April 1986; & JP-A-60 247 940 (HITACHI SEISAKUSHO K.K.) 07-12-1985
- PATENT ABSTRACTS OF JAPAN, vol. 8, no. 250 (E-279)[1687], 16th November 1984; & JP-A-59 126 650 (NIPPON DENSO K.K.) 21-07-1984
- ENGINEERING, vol. 220, no. 2, February 1980, page 130, London, GB; A. DEAN: "Evolution of the uncommitted logic array"
- ELECTRONIC ENGINEERING, vol. 58, no. 718, October 1986, page 91, London, GB; G. GIANNELLA: "The flexible array technique"
- ELECTRONIC DESIGN, vol. 34, no. 10, May 1986, page 171, Hasbrouck Heights, New Jersey, US; G.GIANNELLA: "Array IC presents new ways to customize analog circuits without wasting silicon"

## Description

### BACKGROUND

The present invention relates to bonding pads for semiconductor chips.

Semiconductor chips have bonding pads which are relatively large areas of metalization providing a contact area for an assembly to solder a wire connection to one of the pins of an integrated circuit package. This wide metal area of the bonding pad is then coupled to the tiny metal connections of the integrated circuit. The semicustom method of designing and fabricating integrated circuits uses prefabricated semiconductor wafers which have completed circuits except for the final process step of device or component interconnection. A cost savings is realized by adapting a standard wafer, which has already been designed and manufactured, to a particular customer's needs by simply designing appropriate metal interconnections. Thus, for each customer, a metal mask is designed which connects the necessary active and passive semiconductor components to form the circuit configuration required by the customer. This method of design and fabrication allows development of a semicustom circuit in less time and at lower cost than if the entire wafer had to be independently designed for each customer.

One limitation in semicustom design is that the number of bonding pads required to form connections to a particular customer's circuit will vary from customer to customer. Accordingly, a standard chip design will have enough bonding pads to accommodate the largest number anticipated to be required by any customer. This results in a number of bonding pads being wasted space for a large number of customers. A bonding pad will typically be a cell area which is simply an N-doped epitaxial layer on top of a P-doped substrate. Inherent in this structure is a clamping diode or a capacitance. For the clamping diode, the N portion of the diode is the epitaxial region and the P portion of the diode is the substrate. The junction capacitor is formed at the junction of the substrate and the epitaxial region. Thus, in some circuit designs, it may be possible to take advantage of this inherent capacitance or clamping diode.

JP-A-60 247 940 describes a semiconductor structure which can be connected as a PNP or an NPN transistor and which includes a metal bonding pad over a P-doped region which extends from a surface into an N-doped epitaxial region.

### SUMMARY OF THE INVENTION

The present invention is concerned with a bonding pad structure which can be connected at the metalization step to form passive or active devices in addition to forming a bonding pad. According to the invention therefore there is provided a programmable bonding pad structure (22; 50; 80) of a semiconductor chip which, by a suitable choice of metalisation can be contacted to form a passive or an active device in addition to forming a bonding pad, the structure comprising:
a P-doped substrate (26; 68; 84);
an N-doped epitaxial region (28; 56; 86) on top of said substrate;
a P-doped region (34; 54; 88; 90) within the epitaxial region extending from its upper surface into said epitaxial region;
a P-doped isolation region (24; 52; 82) surrounding and bordering the bonding pad structure and extending from said upper surface of the epitaxial region to said substrate;
a metal bonding pad (30; 76; 98) over said P-doped region; and
an N+ region (38, 40; 62; 64; 94) formed in said epitaxial region outside of said P-doped region, said N+ region providing an electrical connection to said epitaxial region.

With this arrangement, the P-doped region allows the formation of a junction capacitance between it and the epitaxial layer. In addition an oxide capacitor can be formed between the metal bonding pad and the P-doped region with an oxide layer over the P-doped region as the dielectric. The P-doped region can also be used as a resistance by providing metal connections to both ends. A vertical PNP transistor can be formed between the P-doped region, the epitaxial layer and a P-doped substrate.

There may be provided an N-doped region within the P-doped region and a separate N-doped region outside of the P-doped region so that a NPN transistor can be formed. The outside N-doped region is preferably an N+ region coupling to a buried N+ layer. When not used as an NPN transistor, this buried N+ layer can provide a cross-under to allow routing around metal connections on the surface.

The invention allows the possible formation in the bonding pad structure of an NPN transistor with a single or multiple emitters, a vertical PNP transistor, a junction capacitor in combination with the oxide capacitor, two matched, low value resistors and a cross-under connection. In many applications some of these components can be used at the same time; for example, the bonding pad can be connected to the collector of the NPN transistor and a junction capacitor can be formed between the collector and base of the transistor. Another possible application is the formation of a PNP vertical transistor with a bonding pad connected to its base or its emitter.

In one preferred embodiment, a square shaped P-doped region is formed in the epitaxial layer. A central portion of this P-doped region is doped more heavily to be P+. A series of five N-doped regions are formed along one edge of the lightly P-doped area. Parallel to this, in the adjacent epitaxial region are formed three N+ diffused regions which couple to an N+ buried layer which extends beneath the five N-doped regions.

For a fuller understanding of the nature and advantages of the invention, reference should be made to the ensuing detailed description taken in conjunction with the accompanying drawings.

### BRIEF DESCRIPTION OF THE DRAWINGS

Figures 1 and 1A are diagrams of a prior art bonding pad structure;
Figures 2 and 2A are diagrams of the top and cross-section views, respectively, of a simple programmable bonding pad structure according to the present invention;
Figures 2B-2E are schematic diagrams of various circuits formed from the structure of Figure 2;
Figures 3, 3A and 3B are diagrams of the top and two cross-sectional views of a programmable bonding pad structure according to an alternate embodiment of the present invention, where a lateral PNP transistor is also generated;
Figures 3C and 3D are schematic diagrams of a PNP and NPN transistor, respectively, formed from the structure of Figure 3;
Figures 4 and 4A are surface and cross-section views of a second alternate embodiment of the programmable bonding pad structure according to the present invention; and
Figures 5A-5F are schematic diagrams of the embodiment of Figure 4 coupled as a parallel junction and oxide capacitor, an NPN transistor, a PNP transistor, and a circuit having a bonding pad, junction and oxide capacitors and PNP and NPN transistors, respectively.

### DETAILED DESCRIPTION OF THE PREFERRED EMBODIMENTS

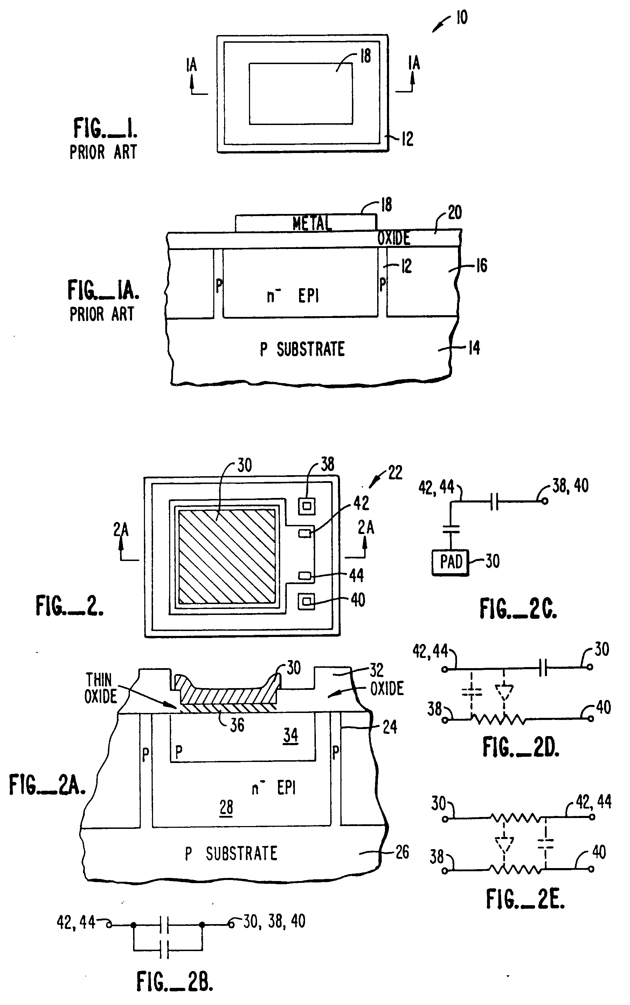

Figure 1 shows a prior art bonding pad structure 10, which is shown in cross-section in Figure 1A. structure 10 is bordered with a P-doped isolation boundary 12 connecting the surface of the cell to a P-doped substrate 14 through epitaxial region 16. A metal layer 18 forms the bonding pad on top of an oxide layer 20. This structure has an inherent clamping diode between N-doped epitaxial region 16 and P-doped substrate 14, as well as a junction capacitance between these regions.

Figures 2 and 2A show a first embodiment of the present invention. A bonding pad structure 22 is bordered by a P-doped isolation region 24 which connects the surface to a P-doped substrate 26 through N-doped epitaxial region 28. A metal bonding pad 30 is placed in an opening in oxide layer 32. Beneath metal layer 30 is a P-doped region 34. A thin oxide layer 36 separates bonding pad 30 from P-doped region 34. In addition, a pair of N+ regions 38, 40 provide connections to epitaxial region 28.

The structure of Figure 2 can be used to form a junction capacitor between P-doped region 34 and N-doped epitaxial region 28. This can be done by providing a metal connection directly to P-doped region 34 by omitting at least a portion of thin oxide layer 36 or through openings 42, 44 in oxide layer 32. A connection to the epitaxial region 28 is provided by one or both of N+ regions 38 and 40. Alternately, an oxide capacitor is formed between P-doped region 34 and metal bonding pad 30. A connection to P-doped region 34 is provided through openings in oxide layer 32 at openings 42 and 44.

The structure 22 can be used as a resistor by providing metal connections to openings 42 and 44 and using P-doped region 34 as a resistance. Alternately, metal connections can be provided to N+ regions 38 and 40 to provide a low resistance cross-under through epitaxial region 28.

Some of the circuits that can be formed from the cell of Figure 2 are shown in Figures 2B-2E. Figure 2B shows a junction and an oxide capacitance in parallel. Figure 2C shows a bonding pad coupled by an oxide capacitance to a first contact which is coupled by a junction capacitance to a second contact. Figure 2D shows the formation of a low resistance cross-under between N+ regions 38 and 40. A parasitic capacitance and diode are shown in phantom. Figure 2E shows the formation of two resistances, with the first resistance being the low resistance cross-under of Figure 2D and the second resistance being formed between contacts in openings 42 and 44 and bonding pad 30, with oxide layer 36 being omitted. In this configuration, pad 30 preferably only contacts P-doped region 34 at the end opposite the contacts in openings 42, 44. Again, parasitic capacitance and a parasitic diode are shown in phantom.

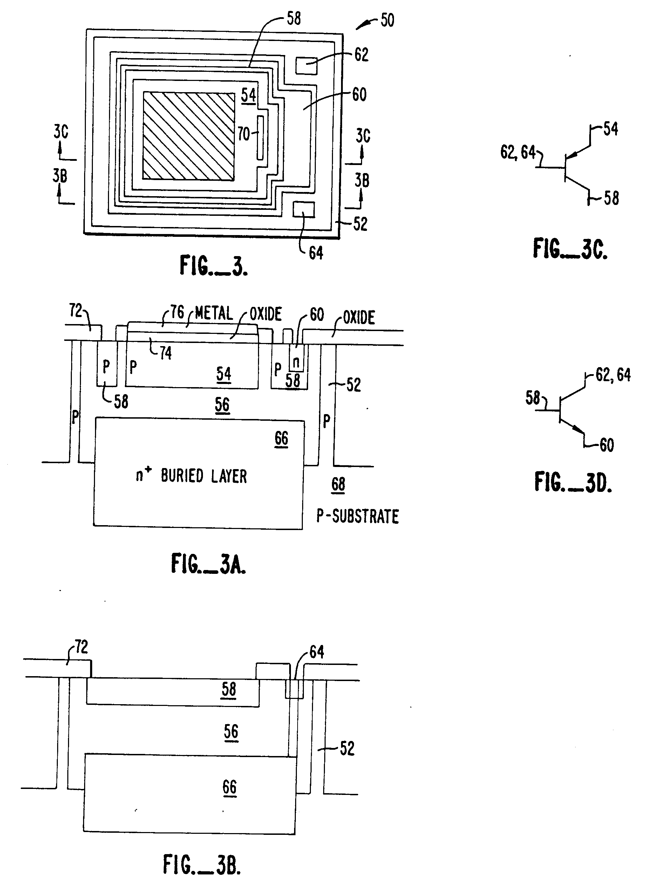

Figures 3-3B show a second embodiment of the present invention. A bonding pad structure 50 is surrounded by a P-doped isolation region 52 and has a central P-doped region 54 in epitaxial layer 56. A second P-doped region 58 surrounds P-doped region 54. An N-doped region 60 is located within P-doped region 58 along a first side of the cell. Additional N+ doped regions 62, 64 are coupled to a buried N+ layer 66.

A PNP transistor can be formed from the structure of Figure 3 by making the connections shown in Figure 3C, and an NPN transistor can be formed by making the connections shown in Figure 3D.

In addition, an oxide or junction capacitance can be formed in the same manner as shown for Figure 2 with a contact region 70 providing a connection to P-doped region 54 through oxide layer 72. A thin oxide layer 74 can be deposited on top of P-doped region 54 and a metal bonding pad 76 can be applied on top of thin oxide layer 74 to form an oxide capacitance between metal bonding pad 76 and P-doped region 54. Alternately, or in addition, metal bonding pad 76 can be used with oxide layer 74 either present or eliminated.

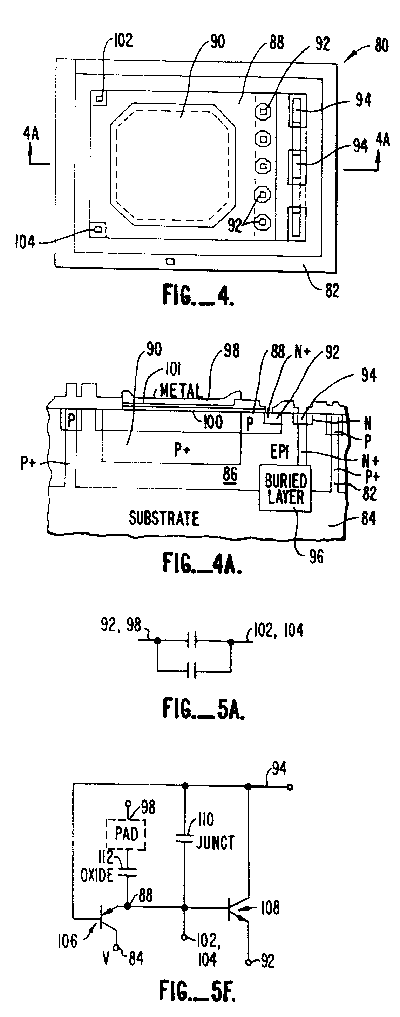

Figure 4 shows a top view of a bonding pad structure 80 according to another embodiment of the present invention. Figure 4A is a cross-sectional view along lines 4A-4A of Figure 4. The structure is bordered by a P-doped isolation region 82 which couples to the P-doped substrate 84 forming an epitaxial island 86. A lightly P-doped region 88 is provided and has an internal more highly doped P+ region 90. A series of five N-doped regions 92 are located along the perimeter of one edge of P-doped region 88. Three N+ doped regions 94 provide connections to a buried N+ layer 96. A bonding pad 98 is formed over an optional thin oxide layer 100 on top of P-doped region 88.

Figures 5A-5F show various circuits which can be formed with the structure of Figure 4. In Figure 5A a junction and an oxide capacitance connected in parallel are shown. The oxide capacitor is formed by the common method where one plate is the aluminum metalization and the other plate is a diffused area. However, instead of using the N+ region of an emitter diffusion as in the common fabrication method, a P diffusion is used instead. This automatically creates another capacitor, a junction capacitor, between P region 88 and N-doped epitaxial region 86. The two capacitors can be connected in parallel by connecting the metal bonding pad 98 to N+ regions 92. If the oxide thickness of thin oxide layer 100 is 1800 x 10⁻¹⁰m (1800 angstroms), the capacitance is 0.12 pF (picofarads) per square mils (1 mil = 0,0254 mm). For an epitaxial resistivity of 2 ohm-cm, the junction capacitor has a value of about 0.03 x 10¹⁰ pF per square mils (0.2 pF per square mils).

P+ region 90 can be used to form two matched low value resistors through P+ region 90 between metal bonding pad 98 (with oxide layer 100 omitted) and a pair of contact areas 102, 104.

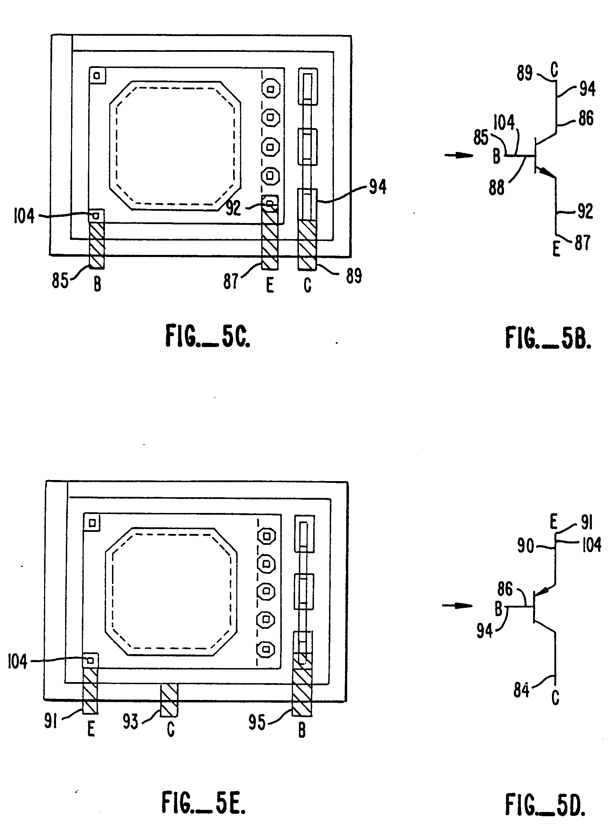

An NPN transistor can be formed as shown in Figure 5B with either or both of contacts 102, 104 providing the base contact, regions 92 forming the emitter and regions 94 forming the collector. Lightly doped P region 88 is the region coupled to by contact areas 102 and 104, providing the base of the transistor.

Figure 5C shows one example of the metal connections that can be made on the structure of Figure 4 to form the circuit of Figure 5B. Metal 85 connects to contact area 104 to provide the base connection, metal 87 connects to a region 92 to provide the emitter connection, and metal 89 connects to a region 94 to provide the collector connection.

Figure 5D shows the connection of cell 80 of Figure 4 as a PNP transistor. P+ region 90 forms the emitter of the transistor, N+ diffusion regions 94 to buried layer 96 couple to epitaxial region 86 to form the base of the transistor, and substrate 84 is the collector of the transistor. The substrate is usually coupled to the most negative voltage, so this transistor has its collector coupled to the most negative voltage. The performance of this device is much better than the usual vertical PNP because of the higher emitter concentration and the thinner base obtained with the deep P+ diffusion region 90.

Figure 5E shows one example of the metal connections that can be made on the structure of Figure 4 to form the transistor of Figure 5D. Metal 91 connects to contact area 104 to provide the emitter connection, metal 93 connects to isolation region 82, which is connected to substrate 84, to form the collector connection and metal 95 is connected to a region 94 to provide the base connection.

Metal bonding pad 98 can be used as a bonding pad in connection with the other functions at all times, unless the 0.6 pF capacitor between the pad and P-doped region 88 affects the circuit performance. The normal width of oxide layer 100 would be about 6000 x 10⁻¹⁰m (6000 angstroms), but when a higher value oxide capacitor is required, the oxide thickness can go below 2000 x 10⁻¹⁰m (2,000 angstroms).

Figure 5F shows how NPN and PNP transistors along with junction and oxide capacitors and the bonding pad are connected together. The collector of a PNP transistor 106 is tied to substrate 84 which will normally be ground or the most negative voltage. The base 94 of PNP transistor 106 also forms the collector of an NPN transistor 108 and one side of a junction capacitor 110. Metal bonding pad 98 is one end of an oxide capacitor 112 with the other end being P-doped region 88, which also forms the other side of junction capacitor 110, as well as the base of NPN transistor 108 and the emitter of PNP transistor 106. The contact to P-doped region 88 is provided through areas 102 and 104. The emitter of NPN transistor 108 is contacted through regions 92.

The present invention provides several advantages over existing semicustom designs in addition to the programmability of the bonding pad area which prevents it from being a wasted area when not used as a bonding pad. For instance, most semicustom designs do not provide integrated capacitors which are provided in the present invention. By placing the bonding pad on the periphery of the semiconductor chip, the capacitors are also on the periphery of the semiconductor chip and thus do not interfere with the routing of internal connections on the chip. By connecting the transistors of several pad structures in parallel, a high current transistor can be obtained which is ideal for an input/output interface. When not otherwise used, N+ regions 94 can provide a cross-under connection through buried layer 96.

Standard processing methods can be used to produce the bonding pad structures according to the present invention. The substrate is first doped to be P. The N+ buried layer is then diffused and the N- epitaxial region is grown. Each diffusion step is performed using the standard steps of growing an oxide, depositing a photoresist coating, masking the coating, bombarding the wafer with ultraviolet light, dissolving away the noncross-linked part of the photoresist and then etching through the silicon dioxide to expose regions where diffusion will take place.

After the epitaxial region is grown, the deep P+ diffusion to form the isolation borders for the cell is done. Thereafter, the P diffusions are done, the N diffusions are done and the oxide is etched to form the contact regions for the cell. Metalization is done according to the standard techniques of applying aluminium over the wafer, photomasking and etching away everywhere except where connections are desired.

## Claims

1. A programmable bonding pad structure (22; 50; 80) of a semiconductor chip which, by a suitable choice of metalisation can be contacted to form a passive or an active device in addition to forming a bonding pad, the structure comprising:
a P-doped substrate (26; 68; 84);
an N-doped epitaxial region (28; 56; 86) on top of said substrate;
a P-doped region (34; 54; 88; 90) within the epitaxial region extending from its upper surface into said epitaxial region;
a P-doped isolation region (24; 52; 82) surrounding and bordering the bonding pad structure and extending from said upper surface of the epitaxial region to said substrate;
a metal bonding pad (30; 76; 98) over said P-doped region; and
an N+ region (38, 40; 62; 64; 94) formed in said epitaxial region outside of said P-doped region, said N+ region providing an electrical connection to said epitaxial region.

2. The structure of claim 1 further comprising an oxide layer (32; 36; 72; 74; 100) over said P-doped region (34; 54; 88; 90) to form an oxide capacitor.

3. The structure of claim 2 further comprising spaced apart metal contacts connected to said P-doped region (34) through openings (42, 44) in said oxide layer to provide a resistor.

4. The structure of claim 1 or 2 further comprising a second P-doped region (58) disposed within said epitaxial region (56) and surrounding said P-doped region (54) and an N-doped region (60) within said second P-doped region (58).

5. The structure of claim 4 further comprising a metal contact connected to said P-doped region (54) to form the emitter of a PNP transistor, a metal contact connected to said N+ region (62, 64) to form the base of said PNP transistor and a contact to said second P-doped region (58) to form the collector of said PNP transistor.

6. The structure of claim 4 further comprising a metal contact connected to said N+ region (62, 64) to form the collector of an NPN transistor; a metal contact connected to the N-doped region (60) within said second P-doped region (58) to form the emitter of said NPN transistor; and a metal contact connected to said second P-doped region (58) to form the base of said NPN transistor.

7. The structure of one of claims 4 to 6 further comprising an N+ buried layer (66) extending into said P-doped substrate (68), said N+ region (62, 64) being coupled to said N+ buried layer.

8. The structure of claim 1 or 2 with said P-doped region consisting of a lightly P-doped rectangular region (88) and a heavily P-doped region (90) within said lightly P-doped region (88); the structure further comprising:
a plurality of N+doped regions (92) within said lightly P-doped region (88) along a first edge of said lightly P-doped region (88); and
an N+ buried layer (96) extending into said P-doped substrate (84) below said first edge of said lightly P-doped region (88);
the N+ region consisting of a plurality of N+ regions (94) outside said lightly P-doped region (88) proximate said first edge and extending into said N+ buried layer (96) and said N-doped epitaxial region (86).

9. The structure of claim 8 further comprising a metal contact (87) connected to the plurality of said N+ doped regions (92) formed in said lightly P-doped region (88) to form the emitter of an NPN transistor; at least one metal contact (85, 102, 104) connected to said lightly P-doped region (88) to form the base of said NPN transistor; and a metal contact (89) connected to said plurality of N+ regions (94) outside said lightly P-doped region (88) to form the collector of said NPN transistor.

10. The structure of claim 8 further comprising a metal contact (91, 102, 104) connected to said lightly P-doped region (88) to form the emitter of a PNP transistor; a metal contact (95) connected to said plurality of N+ regions outside said lightly P-doped region (88) to form the base of said PNP transistor; and a metal contact (93) connected to said P-doped isolation region (82) which is connected to the substrate (84) to form the collector of said PNP transistor.

## Patentansprüche

1. Programmierbarer Kontaktfleck (22; 50; 80) auf einem Halbleiter-Chip, welcher durch geeignete Metallisierung derart zu kontaktieren ist, daß er ein passives oder ein aktives Element und zusätzlich einen Kontaktfleck bildet, der folgende Merkmale aufweist:
ein p-dotiertes Substrat (26; 68; 84);
eine n-dotierte, epitaxiale Schicht (28; 56; 86) auf dem Substrat;
eine p-dotierte Schicht (34; 54; 88; 90) innerhalb der epitaxialen Schicht, die sich von deren Oberfläche in die epitaxiale Schicht hinein erstreckt;
eine p-dotierte Isolierschicht (24; 52; 82), die den Kontaktfleck umgibt und begrenzt, und die sich von der Oberfläche der epitaxialen Schicht zu dem Substrat erstreckt;
einen über der p-dotierten Schicht angeordneten Metall-Kontaktfleck (30; 76; 98); und
eine n⁺-Schicht (38, 40; 62; 64; 94), die in der epitaxialen Schicht außerhalb der p-dotierten Schicht angeordnet ist und eine elektrische Verbindung zu der epitaxialen Schicht bildet.

2. Kontaktfleck nach Anspruch 1
mit einer über der p-dotierten Schicht (34; 54; 88; 90) angeordneten Oxidschicht (32; 36; 72; 74; 100) zur Bildung eines Oxidkondensators.

3. Kontaktfleck nach Anspruch 2
mit auf Abstand liegenden Metallkontakten, die über Löcher (42, 44) in der Oxidschicht mit der p-dotierten Schicht (34) verbunden sind zur Bildung eines Widerstandes.

4. Kontaktfleck nach Anspruch 1 oder 2
mit einer zweiten p-dotierten Schicht (58), die innerhalb der epitaxialen Schicht (56) angeordnet ist und die p-dotierte Schicht (54) und eine n-dotierte Schicht (60) umgibt, die innerhalb der zweiten p-dotierten Schicht (58) angeordnet ist.

5. Kontaktfleck nach Anspruch 4
mit einem Metallkontakt, der an die p-dotierte Schicht (54) zur Bildung des Emitters eines pnp-Transistors angeschlossen ist, einem Metallkontakt, der an die n⁺-Schicht (62, 64) zur Bildung der Basis des pnp-Transistors angeschlossen ist, und einem Kontakt, der an die zweite p-dotierte Schicht (58) zur Bildung des Kollektors des pnp-Transistors angeschlossen ist.

6. Kontaktfleck nach Anspruch 4
mit einem Metallkontakt, der an die n⁺-Schicht (62, 64) zur Bildung des Kollektors eines npn-Transistors angeschlossen ist; einem Metallkontakt, der an die n-dotierte Schicht (60) innerhalb der zweiten p-dotierten Schicht (58) angeschlossen ist, um den Emitter des npn-Transistors zu bilden; und einem Metallkontakt, der an die zweite p-dotierte Schicht (58) zur Bildung der Basis des npn-Transistors angeschlossen ist.

7. Kontaktfleck nach einem der Ansprüche 4 bis 6
mit einer überdeckten n⁺-Schicht (66), die sich in das p-dotierte Substrat (68) hinein erstreckt, wobei die genannte n⁺-Schicht (62, 64) mit der überdeckten n⁺-Schicht gekoppelt ist.

8. Kontaktfleck nach Anspruch 1 oder 2,
bei dem die p-dotierte Schicht aus einer schwach p-dotierten, rechteckigen Schicht (88) und einer innerhalb der schwach p-dotierten Schicht (88) angeordneten, stark p-dotierten Schicht (90) besteht; und mit
mehreren n⁺-dotierten Schichten (92) innerhalb der schwach p-dotierten Schicht (88), die an einem ersten Rand der schwach p-dotierten Schicht (88) angeordnet sind; und
einer überdeckten n⁺-Schicht (96), die sich unter dem ersten Rand der schwach p-dotierten Schicht (88) in das p-dotierte Substrat (84) hinein erstreckt;
und bei dem die n⁺-Schicht aus mehreren n⁺-Schichten (94) außerhalb der schwach p-dotierten Schicht (88) in der Nähe des ersten Randes besteht und sich in die überdeckte n⁺-Schicht (96) und die n-dotierte, epitaxiale Schicht (86) hinein erstreckt.

9. Kontaktfleck nach Anspruch 8
mit einem Metallkontakt (87), der an die Vielzahl von innerhalb der schwach p-dotierten Schicht (88) ausgebildeten, n⁺-dotierten Schichten (92) angeschlossen ist, um den Emitter eines npn-Transistors zu bilden; mindestens einem Metallkontakt (85, 102, 104), der an die schwach p-dotierte Schicht (88) angeschlossen ist, um die Basis des npn-Transistors zu bilden; und einem Metallkontakt (89), der an die Vielzahl von n⁺-Schichten (94) angeschlossen ist, die außerhalb der schwach p-dotierten Schicht (88) liegen, um den Kollektor des npn-Transistors zu bilden.

10. Kontaktfleck nach Anspruch 8
mit einem Metallkontakt (91, 102, 104), der an die schwach p-dotierte Schicht (88) angeschlossen ist, um den Emitter eines pnp-Transistors zu bilden; einem Metallkontakt (95), der an die Vielzahl von n⁺-Schichten außerhalb der schwach p-dotierten Schicht (88) angeschlossen ist, um die Basis des pnp-Transistors zu bilden; und einem Metallkontakt (93), der an die mit dem Substrat (84) verbundene, p-dotierte Isolierschicht (82) angeschlossen ist, um den Kollektor des pnp-Transistors zu bilden.

## Revendications

1. Structure de plage de contact programmable (22 ; 50 ; 80) d'une plaquette à semiconducteur qui, par un choix approprié de métallisation peut être reliée pour former un dispositif actif ou passif en plus de former une plage de contact, la structure comprenant :
- un substrat dopé P (26 ; 68 ; 84),
- une région épitaxiale dopée N (28 ; 56 ; 86) sur ledit substrat,
- une région dopée P (34 ; 54 ; 88 ; 90) dans la région épitaxiale s'étendant à partir de sa surface supérieure dans ladite région épitaxiale,
- une région d'isolation dopée P (24 ; 52 ; 82) entourant et encadrant la structure de plage de contact et s'étendant à partir de ladite surface supérieure de la région épitaxiale vers ledit substrat,
- une plage de contact métallique (30 ; 76 ; 98) sur ladite région dopée P, et
- une région N+ (38, 40 ; 62 ; 64 ; 94) formée dans ladite région épitaxiale hors de ladite région dopée P, ladite région N+ fournissant une connexion électrique à ladite région épitaxiale.

2. Structure selon la revendication 1, comprenant en outre une couche d'oxyde (32 ; 36 ; 72 ; 74 ; 100) sur ladite région dopée P (34 ; 54 ; 88 ; 90) pour former un condensateur à oxyde.

3. Structure selon la revendication 2, comprenant en outre des contacts métalliques espacés connectés à ladite région dopée P (34) à travers des ouvertures (42, 44) dans ladite couche d'oxyde pour fournir une résistance.

4. Structure selon la revendication 1 ou 2 comprenant en outre une seconde région dopée P (58) disposée dans ladite région épitaxiale (56) et entourant ladite région dopée P (54) et une région dopée N (60) dans ladite seconde région dopée P (58).

5. Structure selon la revendication 4, comprenant en outre un contact métallique connecté à ladite région dopée P (54) pour former l'émetteur d'un transistor PNP, un contact métallique connecté à ladite région N+ (62, 64) pour former la base dudit transistor PNP et un contact à ladite seconde région dopée P (58) pour former le collecteur dudit transistor PNP.

6. Structure selon la revendication 4, comprenant en outre un contact métallique connecté à ladite région N+ (62, 64) pour former le collecteur d'un transistor NPN ; un contact métallique connecté à la région dopée N (60) dans ladite seconde région dopée P (58) pour former l'émetteur dudit transistor NPN ; et un contact métallique connecté à ladite seconde région dopée P (58) pour former la base dudit transistor NPN.

7. Structure selon l'une quelconque des revendications 4 à 6, comprenant en outre une couche enterrée N+ (66) s'étendant dans ledit substrat dopé P (68), ladite région N+ (62, 64) étant couplée à ladite couche enterrée N+.

8. Structure selon la revendication 1 ou 2 avec ladite région dopée P consistant en une région rectangulaire légèrement dopée P (88) et une région fortement dopée P (90) dans ladite région légèrement dopée P (88) ; la structure comprenant en outre :
plusieurs régions dopées N+ (92) dans ladite région légèrement dopée P (88) le long d'un premier bord de ladite région légèrement dopée P (88) ; et
une couche enterrée N+ (96) s'étendant dans ledit substrat dopé P (84) au-dessous dudit premier bord de ladite région légèrement dopée P (88) ;
la région N+ consistant en plusieurs régions N+ (94) hors de ladite région légèrement dopée P (88) à proximité dudit premier bord et s'étendant dans ladite couche enterrée N+ (96) et ladite région épitaxiale dopée N (86).

9. Structure selon la revendication 8, comprenant en outre un contact métallique (87) connecté auxdites plusieurs régions dopées N+ (92) formées dans ladite région légèrement dopée P (88) pour former l'émetteur d'un transistor NPN ; au moins un contact métallique (85, 102, 104) connecté à ladite région légèrement dopée P (88) pour former la base dudit transistor NPN ; et un contact métallique (89) connecté auxdites plusieurs régions N+ (94) hors de ladite région légèrement dopée P (88) pour former le collecteur dudit transistor NPN.

10. Structure selon la revendication 8, comprenant en outre un contact métallique (91, 102, 104) connecté à ladite région légèrement dopée P (88) pour former l'émetteur d'un transistor PNP ; un contact métallique (95) connecté auxdites plusieurs régions N+ hors de ladite région légèrement dopée P (88) pour former la base dudit transistor PNP ; et un contact métallique (93) connecté à ladite région d'isolation dopée P (82) qui est connectée au substrat (84) pour former le collecteur dudit transistor PNP.
